(19) Europäisches Patentamt
European Patent Office
Office européen des brevets

(11) **EP 2 871 487 A1**

(12) **EUROPEAN PATENT APPLICATION**

(43) Date of publication:
**13.05.2015 Bulletin 2015/20**

(51) Int Cl.:
***G01R 27/00*** *(2006.01)*     ***G01R 31/26*** *(2014.01)*

(21) Application number: **13192357.5**

(22) Date of filing: **11.11.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Capres A/S**
**2800 Lyngby (DK)**

(72) Inventors:
 • **Henrichsen, Henrik Hartmann**
  **2300 København S (DK)**
 • **Petersen, Dirch Hjorth**
  **2870 Dyssegård (DK)**
 • **Hansen, Ole**
  **2970 Hørsholm (DK)**

(74) Representative: **Budde Schou A/S**
  **Hausergade 3**
  **1128 Copenhagen K (DK)**

(54) **Small scale measurements of anisotropic sheet conductances**

(57) In a method of determining a pair of spatial components of an anisotropio sheet conductance of a conductive sheet (52) with a multi-point probe (30), the conductive sheet has an edge (56) and defines an axis of highest conductance and an axis of lowest conductance. The multi-point probe comprises a plurality of contact elements (32-38), and each contact element defines a contact point (42-48) for contacting and establishing an electrical connection to the conductive sheet. The contact points of the plurality of contact elements are spatially separated from one another and positioned in a collinear relationship. The method comprises determining a first parameter value representing the spatial separation between the contact points, contacting the conductive sheet with the contact points of the plurality of contact elements at a first position on the conductive sheet, determining a second parameter value representing the distance between the first position and the edge of the conductive sheet, selecting a first and a second pair of contact elements from the plurality of contact elements, performing a first four-point measurement with the first pair of contact elements as current leads and the second pair of contact elements as voltage leads for determining a resistance value defining a third parameter value, defining a first quantity and a second quantity representing the conductance of the conductive sheet along the axis of highest conductance and representing the conductance of the conductive sheet along the axis of lowest conductance, respectively, defining a model describing a relation between the first and second quantities and the first, second, and third parameter values, and determining the first and/or the second quantities by employing the first, second, and third parameter values in the model.

FIG. 1

**Description**

The present invention relates to the determination of a sheet conductance. In particular, it relates to the determination of the components of an anisotropic sheet conductance in a conductive sheet, such as a thin metal film.

In sheet conductance measurements on conductive sheets, it is known in the art that collinear multi-point probe measurements give the geometric mean in the plane of the sheet. This problem has been overcome by using a multi-point probe with contact points spread out in a two-dimensional square pattern on the conductive sheet, rather than in the one dimensional linear arrangement, see for example Phys. Rev. Lett., Vol. 91, No. 3, 036805, 2003, and USH585H.

In contrast with common two-dimensional square pattern probe variants, the collinear multi-point probe can easier be manufactured at a very small scale by micro-fabrication techniques, see for example US2004/0056674A1, which allows for measurements at a much higher spatial resolution. Thus, it is an object of the present invention to determine the components of an anisotropic sheet conductance of a conductive sheet at a higher spatial resolution, which is achieved by the different aspects of the present invention described below.

The first aspect of the present invention encompasses a method of determining a pair of components of an anisotropic sheet conductance of a conductive sheet with a multi-point probe, the conductive sheet having an edge and defining an axis of highest conductance and an axis of lowest conductance, and the multi-point probe comprising a plurality of contact elements, and each contact element defining a contact point for contacting and establishing an electrical connection to the conductive sheet, and the contact points of the plurality of contact elements being spatially separated from one another and positioned in a collinear relationship, the method comprising:

determining a first parameter value representing the spatial separation between the contact points,
contacting the conductive sheet with the contact points of the plurality of contact elements at a first position on the conductive sheet,
determining a second parameter value representing the distance between the first position and the edge of the conductive sheet,
selecting a first pair of contact elements and a second pair of contact elements from the plurality of contact elements, and the contact elements of the first pair being different from the contact elements of the second pair,
performing a first four-point measurement with the first pair of contact elements as current leads and the second pair of contact elements as voltage leads for determining a resistance value defining a third parameter value,
defining a first quantity representing the conductance of the conductive sheet along the axis of highest conductance and a second quantity representing the conductance of the conductive sheet along the axis of lowest conductance, the first and second quantities representing the pair of components,
defining a model describing a relation between the first and second quantities and the first, second, and third parameter values, and
determining the first and/or the second quantities by employing the first, second, and third parameter values in the model.

The conductive sheet may define a planar surface. The conductive sheet may be of a conductive material, such as a metal, a semiconductor material doped with impurities, or an electrically conductive polymer. The conductive sheet may be located on or part of a wafer or substrate of a semiconductor material, such as a silicon crystal or an insulator such as silicon dioxide. The edge may be the boundary between the conductive material and a non-conductive material. The edge may also be the physical edge of the wafer or substrate, or it may be the physical edge resulting from a photolithography based etching. The edge encompasses an edge providing an electrical isolation of the conductive surface.

That the plurality of contact elements being spatially separated from one another should be understood as encompassing the plurality of contact elements being spaced apart. Positioned in a collinear relationship should be understood as encompassing the plurality of contact elements being intersected by a single line.

The method according to the first aspect of the present invention may further comprise:

contacting the conductive sheet with the contact points of the plurality of contact elements at a second position on the conductive sheet,
determining a fourth parameter value representing the distance between the second position and the edge of the conductive sheet,
performing a second four-point measurement with the first pair of contact elements as current leads and the second pair of contact elements as voltage leads for determining a resistance value defining a fifth parameter value: and
the model may comprise a function with an output representing a resistance value determined by a four-point measurement with the first pair of contact elements as current leads and the second pair of contact elements as voltage leads, a known constant representing the first parameter value, a first unknown constant representing the first quantity, a second unknown constant representing the second quantity, and a variable representing the distance from the first and second positions to the edge; and

the step of determining the first and second quantities may further comprise: adjusting the first unknown and the second unknown for fitting the function to the second parameter value paired with the third parameter value and the fourth parameter value paired with the fifth parameter value.

Alternatively to the further specification above in which the fourth parameter value represents the distance between the second position and the edge of the conductive sheet, the method according to the first aspect of the present invention may further comprise:

contacting the conductive sheet with the contact points of the plurality of contact elements at a second position on the conductive sheet,
determining a fourth parameter value representing the distance between the first position and the second position,
performing a second four-point measurement with the first pair of contact elements as current leads and the second pair of contact elements as voltage leads for determining a resistance value defining a fifth parameter value: and
the model may comprise a function with an output representing a resistance value determined by a four-point measurement with the first pair of contact elements as current leads and the second pair of contact elements as voltage leads, a known constant representing the first parameter value, a first unknown constant representing the first quantity, a second unknown constant representing the second quantity, and a variable representing the distance from the first and second positions to the edge; and
the step of determining the first and second quantities may further comprise: adjusting the first unknown and the second unknown for fitting the function to the second parameter, the third parameter value, the fourth parameter value and the fifth parameter value.

The method according to the first aspect of the present invention may further comprise: orienting the contact points in a parallel relationship with the axis of highest conductance or the axis of lowest conductance. The edge may comprise a straight edge portion, and the method according to the first aspect of the present invention may further comprise: orienting the contact points in a parallel relationship with the straight edge portion. The edge may comprise a straight edge portion that is parallel to the axis of highest conductance or the axis of lowest conductance, and the method may further comprise: orienting the contact points in a parallel relationship with the straight edge portion. The orienting of the contact points may be done before or during the step of contacting the conductive sheet.

The second parameter value may represent the shortest distance between the first position and the edge of the conductive sheet. Alternatively or additionally, the second parameter value may represent the shortest distance between the first position and the straight edge portion of the conductive sheet. This may be done visually, by tracking coordinates in the supporting equipment, or by a method involving multipoint measurements, for example as disclosed in WO2012/083955. Determining a second parameter value representing the distance between the first position and the edge of the conductive sheet is understood to encompass performing an additional four point measurement for determining an additional resistance value representing the second parameter. This means that the second parameter implicitly represents the distance and that when the second parameter is employed in the model, the additional four point measurement is effectively used for reducing the distance dependence of the model.

The method according to the first aspect of the present invention may further comprise: determining the orientation of the contact points relative to the axis of highest conductance; and the step of defining a model may further comprise: the model being adjusted to reflect the determined orientation of the contact points relative to the axis of highest conductance.

If the axis of highest conductance and the axis of lowest conductance are not known, then the method according to the first aspect may further comprise: - determining the axis of highest conductance and the axis of lowest conductance. The determining may be performed at the manufacturing of the wafer. For example, the conductive sheet may be produced by sputtering a metal layer having ferromagnetic properties on a wafer or substrate and subsequently annealing it in a magnetic field having a known direction for forming a magnetic easy axis in the direction of the magnetic field. In this process, the magnetic field is parallel to the magnetic easy axis, and the latter is therefore known. The magnetic easy axis is parallel to the axis of lowest conductance, which is therefore also known.

The method according to the first aspect of the present invention may further comprise: determining the orientation of the contact points relative to the straight edge portion; and the step of defining a model may further comprise: the model being adjusted to reflect the determined orientation of the contact points relative to the straight edge portion.

The multi-point probe may be symmetric, which encompasses the contact points being evenly spaced apart. In a different wording, each pair of neighbouring contact points may be spaced apart with the same separating distance. Alternatively, the multi-point probe may be asymmetric, which encompasses neighbouring contact points being spaced apart with varying separating distances. The first parameter value representing the spatial separation of the contact points should be understood as encompassing the first parameter value representing the spatial separation of two of the contact points, which two contact points may be neighbouring contact points. The first parameter value may be the separating distance or spatial separation between two neighbouring contact points. The model may depend also on one or more additional separating distances or spatial separations between neighbouring or non-neighbouring contact points. This means that the separating distances or spatial separations of two different pairs of contact points of an asymmetric multi-point probe may be employed in the model, for example by the first parameter representing a mean of the separating distances.

The ratio of the second parameter value over the first parameter value may be below 10, or 20, or 100, preferably below 2 or 1. Similarly, the ratio of the fourth parameter value over the first parameter value may be below 10, or 20, or 100, preferably below 2 or 1. The lower the value, the greater the signal to noise will become in the measurement.

The model describing a relation between the first and second quantities and the first, second, and third (and optionally fourth and/or fifth) parameter values may be based on a relation equivalent to:

$$\nabla \cdot \mathbf{J_s} = I_0 \, \delta(\mathbf{r} - \mathbf{r}_0),$$

where

$\mathbf{J_s}$ is a vector representing the sheet current density, $I_0$ is a number representing the current injected by one of the current leads at the first position represented by the vector $\mathbf{r}_0$, and $\delta$ represents the Kronecker delta function, and on a relation equivalent to:

$$\mathbf{J_s} = \mathbf{G} \, \mathbf{E},$$

where

$\mathbf{J_s}$ is the vector representing the sheet current density, $\mathbf{E}$ is a vector representing the electrical field generated by the current injected by the current leads, and $\mathbf{G}$ is a matrix representing a sheet conductance tensor based at least on the determined orientation of the contact points relative to the axis of highest conductance and on the first and second quantities. The method according to the first aspect of the present invention may further comprise: - diagonalizing $\mathbf{G}$.

The model may be based on a relation equivalent to:

$$\Phi = \frac{I_0}{2\pi\sqrt{G_{xx}G_{yy}}} \ln \frac{1}{\sqrt{\sqrt{\frac{G_{yy}}{G_{xx}}}(x - x_0)^2 + \sqrt{\frac{G_{xx}}{G_{yy}}}(y - y_0)^2}},$$

where

$\Phi$ is the potential at a point on the conductive sheet represented by the coordinates x and y, $I_0$ is a number representing the current injected by one of the current leads at the first position represented by the coordinates $x_0$ and $y_0$, $G_{xx}$ is the first quantity, and $G_{yy}$ is the second quantity.

The plurality of contact elements may be constituted by a first, a second, a third, and a fourth contact element, and the contact points of the first, a second, a third, and a fourth contact element may be ordered sequentially in the collinear relationship; and the first pair of contact elements may consist of the first and fourth contact elements, and the second pair of contact elements may consist of the second and third contact elements, or the first pair of contact elements may consist of the second and third contact elements, and the second pair of contact elements may consist of the first and fourth elements.

That the contact elements are ordered sequentially in the collinear relationship encompasses the contact elements being intersected by a single line in the order: first contact element, second contact element, third contact element, and fourth contact element along the single line.

The model may be based on a function equivalent to:

$$R_A(y) = \frac{1}{2\pi\sqrt{G_{xx}G_{yy}}}\ln\left(4\frac{4\frac{G_{xx}}{G_{yy}}\left(\frac{y}{s}\right)^2 + 4}{4\frac{G_{xx}}{G_{yy}}\left(\frac{y}{s}\right)^2 + 1}\right),$$

where

s is the first parameter value, $y$ is the second parameter value, $R_A$ is the third parameter value, $G_{xx}$ is the first quantity, and $G_{yy}$ is the second quantity.

The plurality of contact elements may be constituted by a first, a second, a third, and a fourth contact element, and the contact points of the first, a second, a third, and a fourth contact element may be ordered sequentially in the collinear relationship; and the first pair of contact elements may consist of the second and fourth contact elements, and the second pair of contact elements may consist of the first and third contact elements, or the first pair of contact elements may consist of the first and third contact elements, and the second pair of contact elements may consist of the second and fourth contact elements.

The model may be based on a function equivalent to:

$$R_B(y) = \frac{1}{4\pi\sqrt{G_{xx}G_{yy}}}\ln\frac{9\cdot\left(4\frac{G_{xx}}{G_{yy}}\left(\frac{y}{s}\right)^2 + 9\right)}{4\frac{G_{xx}}{G_{yy}}\left(\frac{y}{s}\right)^2 + 1},$$

where

s is the first parameter value, $y$ is the second parameter value, $R_B$ is the third parameter value, $G_{xx}$ is the first quantity, and $G_{yy}$ is the second quantity.

The method according to the first aspect of the present invention may further comprise:

selecting a third pair of contact elements and a fourth pair of contact elements from the plurality of contact elements, the contact elements of the third pair being different from the contact elements of the fourth pair, and at least one contact element of the third pair being different from the contact elements of the first pair, and/or at least one contact element of the fourth pair being different from the contact elements of the second pair, performing a third four-point measurement with the third pair of contact elements as current leads and the fourth pair of contact elements as voltage leads for determining a resistance value defining a sixth parameter value, and the model describing a relation between the first and second quantities and the first, second, third, and sixth parameter values, and the step of determining the first and second quantities further comprises employing the sixth parameter value in the model. These steps may be directly applied to the first aspects in its most basic form as described above, which means that the third four-point measurement effectively is the second measurement in order.

The first and second pair may define the same configuration of current and contact leads as the third and fourth pair. This means that the multi-point probe must have more than four contact elements, such as 5, 12, or 20.

The plurality of contact elements may be constituted by a first, a second, a third, and a fourth contact element, and the contact points of the first, a second, a third, and a fourth contact element being ordered sequentially in the collinear relationship; and the third pair of contact elements may consist of the second and fourth contact element, and the fourth pair of contact elements may consist of the first and third contact element. The model may further be based on a function equivalent to:

$$R_B(y) = \frac{1}{4\pi\sqrt{G_{xx}G_{yy}}} \ln \frac{9 \cdot \left(4\frac{G_{xx}}{G_{yy}}\left(\frac{y}{s}\right)^2 + 9\right)}{4\frac{G_{xx}}{G_{yy}}\left(\frac{y}{s}\right)^2 + 1},$$

where
s is the first parameter value, $y$ is the second parameter value, $R_B$ is the sixth parameter value, $G_{xx}$ is the first quantity, and $G_{yy}$ is the second quantity.

The model may involve the application of the van der Pauw method, or a linear approximation thereof, on the third and sixth parameter values.

The second aspect of the present invention encompasses a system for determining a pair of components of an anisotropic sheet conductance of a conductive sheet on a test sample, the conductive sheet having an edge and defining an axis of highest conductance and an axis of lowest conductance, the system comprising:

(a) a multi-point probe comprising a plurality of contact elements, and each contact element defining a contact point for contacting and establishing an electrical connection to the conductive sheet, and the contact points of the plurality of contact elements being spatially separated from one another and positioned in a collinear relationship,
(b) a support for supporting the test sample,
(c) an actuator for moving the contact elements relative to the conductive sheet and for bringing the contact points of the plurality of contact elements in contact with the conductive sheet, and
(d) a control unit for controlling the actuator and for implementing the method according to any of the claims 1-14.

The movement of the contact elements relative to the conductive sheet may be achieved either by the contact elements being fixed and the conductive sheet being movable, or the contact elements being movable and the conductive sheet being fixed, or by both the contact elements and the conductive sheet being movable.

BRIEF DESCRIPTION OF DRAWINGS

FIG.1 illustrates a four-point probe in contact with an electrically conductive sheet on a test sample.

FIG.2 illustrates the positioning of the contact points relative to an edge portion of a conductive sheet.

FIGS.3A(1-2) illustrate A-type configurations of a four-point measurement.

FIGS.3B(1-2) illustrate B-type configurations of a four-point measurement.

FIG.4 is a block diagram illustrating a preferred method of determining the anisotropic conductance of a conductive sheet.

FIG.5 is a block diagram illustrating an alternative method of determining the anisotropic conductance of a conductive sheet.

FIG.6 illustrates a system implementing a method of determining the anisotropic conductance of a conductive sheet.

FIG.7 is a graph illustrating how the relation between the measured resistances and the distance to the edge of the conductive sheet depends on the anisotropy of the conductance.

FIG.8 illustrates the measurement setup for verifying that the proposed method of determining the anisotropic conductance of a conductive sheet works.

FIG.9 is a graph illustrating the results of the verifying measurements performed in series along an edge parallel to the magnetic easy axis.

FIG.10 is a graph illustrating the results of the verifying measurements performed in series along an edge perpendicular to the magnetic easy axis.

DESCRIPTION

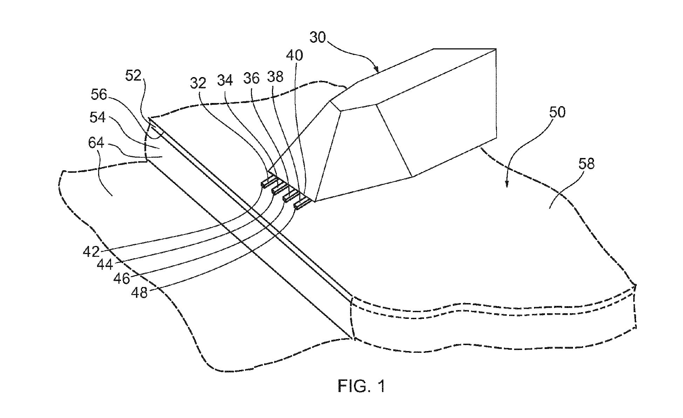

A multi-point probe 30 in contact with an electrically conductive sheet on a test sample is shown in FIG. 1. The multi-point probe 30 has four contact elements 32, 34, 36, and 38 in the form of parallel probe arms extending from its tip 40. The contact elements 32, 34, 36, and 38 individually define the contact points 42, 44, 46, and 48.

The probe is positioned above a test sample 50 in the form of a wafer 54 having a conductive sheet 52 with an edge 56 defined by a lithographic process and isolating the conductive sheet 52 from the surrounding area 64. The conductive sheet 52 defines a planar surface 58 and the multi-point probe 30 is brought into contact with the conductive sheet 52 by touching the contact elements 32, 34, 36, and 38 to the planar surface 58, thus establishing an electrical connection between the multi-point probe 30 and the conductive sheet 52 via the contact points 42, 44, 46, and 48.

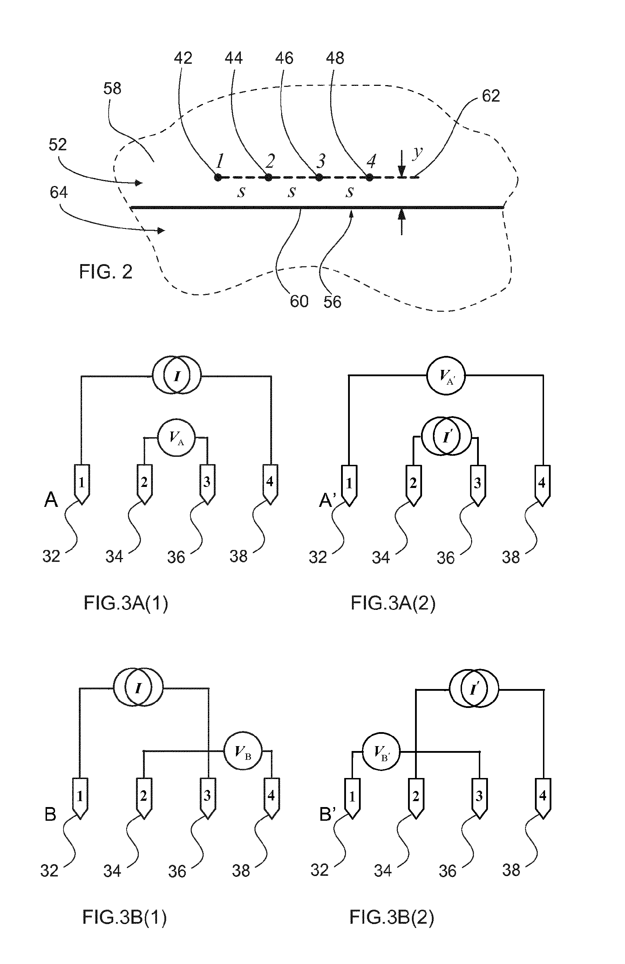

FIG.2 illustrates a preferred positioning of the contact points 42, 44, 46, and 48 on the planar surface 58 of a conductive sheet 52 relative to the closest edge portion 60. The edge portion 60 is straight and the edge 56 forms an isolating boundary to a surrounding area 64. The contact points 42, 44, 46, and 48 are positioned in a linear relationship on a line 62, which is parallel to the straight edge portion 60. The distance $y$ between the line and the straight edge portion 60 represents the distance between the edge 56 and the position on the conductive sheet 52 where it is contacted by the contact elements 32, 34, 36, and 38. The order of the contact points (1 to 4) has been indicated in FIG.2.

FIGS.3A and 3B illustrate four different configurations in which the contact elements 32, 34, 36, and 38 can be employed in a four-point measurement. In FIG.3A(1), the contact elements 32 and 38 form a first pair of current leads and the contact elements 34 and 36 form a second pair of voltage leads, which is called an A-configuration. In FIG.3A(2), the contact elements 34 and 36 form a first pair of current leads and the contact elements 32 and 38 form a second pair of voltage leads, which is called an A'-configuration. In FIG.3B(1), the contact elements 32 and 36 form a first pair of current leads and the contact elements 34 and 38 form a second pair of voltage leads, which is called a B-configuration. In FIG.3B(2), the contact elements 34 and 38 form a first pair of current leads and the contact elements 32 and 36 form a second pair of voltage leads, which is called a B'-configuration.

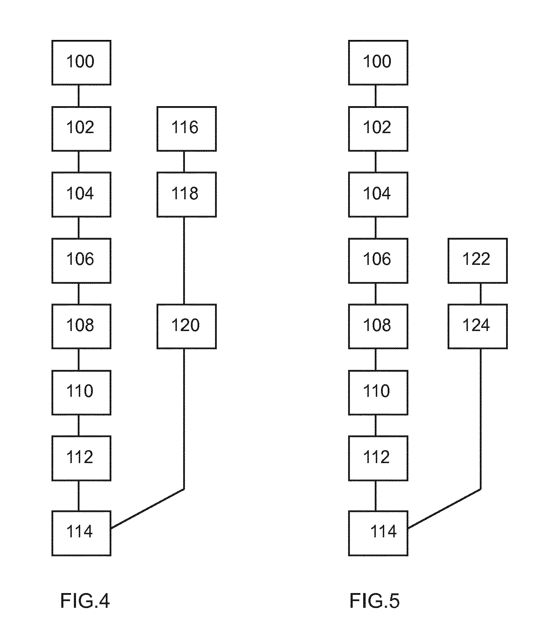

A preferred method of determining the anisotropic conductance of a conductive sheet is illustrated in FIG.4. A first parameter value representing the spatial separation s between the contact points is first determined 100 at the manufacturing of the multi-point probe 30. The conductive sheet 52 is contacted 102 with the contact points 42, 44, 46, and 48 at a first position, and a second parameter value representing the distance between the first position and the edge 56 of the conductive sheet 52 is determined 104. A first pair of contact elements and a second pair of contact elements is selected 106 corresponding to the A- or B-configuration.

The conductive sheet 52 has an axis of lowest conductance and an axis of highest conductance, which are known from the manufacturing of the conductive sheet 52, see further the proof of concept below. The edge portion 60 of the conductive sheet 52 is straight and the contact points 42, 44, 46, and 48 are oriented parallel to the edge portion 60, which in turn is orthogonal to the axis of lowest conductance. A first quantity representing the conductance of the conductive sheet along the axis of highest conductance and a second quantity representing the conductance of the conductive sheet along the axis of lowest conductance are defined 110.

A first four-point measurement with the first pair of contact elements as current leads and the second pair of contact elements as voltage leads is performed and a resistance value defining a third parameter value is determined therefrom 108. The conductive sheet 52 is contacted 116 with the contact points 42, 44, 46, and 48 at a second position on the conductive sheet, and a fourth parameter value representing the distance between the second position and the edge 12 of the conductive sheet 52 is determined 118.

A second four-point measurement with the first pair of contact elements as current leads and the second pair of contact elements as voltage leads is performed 120 for determining a resistance value defining a fifth parameter value.

A model is defined 112 comprising a function with an output representing a resistance value determined by a four-point measurement with the first pair of contact elements as current leads and the second pair of contact elements as voltage leads, a known constant representing the first parameter value, a first unknown constant representing the first quantity, a second unknown constant representing the second quantity, and a variable representing the distance between the first position and the edge. The first unknown and the second unknown are adjusted for fitting 114 the function to the second parameter value paired with the third parameter value and the fourth parameter value paired with the fifth parameter value.

The four contact elements 32, 34, 36, 38 may be constituted by a first, a second, a third, and a fourth contact element, and the contact points of the first, a second, a third, and a fourth contact element are ordered sequentially. The first pair of contact elements consists of the first and fourth contact elements, and the second pair of contact elements consists of the second and third contact elements, which corresponds to an A-configuration depicted in FIG.3A(1). The function used for determining the first and second unknowns is:

$$R_A(y) = \frac{1}{2\pi\sqrt{G_{xx}G_{yy}}} \ln\left( 4\frac{4\frac{G_{xx}}{G_{yy}}\left(\frac{y}{s}\right)^2 + 4}{4\frac{G_{xx}}{G_{yy}}\left(\frac{y}{s}\right)^2 + 1} \right),$$

where
s the is the first parameter value, $y$ the is the second parameter value, $R_A$ is the third parameter value, $G_{xx}$ is the first quantity, and $G_{yy}$ is the second quantity.

Alternatively, the first pair of contact elements consists of the first and third contact elements, and the second pair of contact elements consists of the second and fourth contact elements, which corresponds to a B-configuration depicted in FIG.3B(1). The function forming the base for determining the first and second unknowns is then:

$$R_B(y) = \frac{1}{4\pi\sqrt{G_{xx}G_{yy}}} \ln\frac{9\cdot\left(4\frac{G_{xx}}{G_{yy}}\left(\frac{y}{s}\right)^2 + 9\right)}{4\frac{G_{xx}}{G_{yy}}\left(\frac{y}{s}\right)^2 + 1},$$

where
s the is the first parameter value, $y$ the is the second parameter value, $R_B$ is the third parameter value, $G_{xx}$ is the first quantity, and $G_{yy}$ is the second quantity.

An alternative method of determining the anisotropic conductance of a conductive sheet is illustrated in FIG.5. The steps of this method are the same as in the method described in relation to FIG.4 and have been given the same number indices. Additional to these steps, in the alternative method, a third pair of contact elements and a fourth pair of contact elements are selected 122 corresponding to a B-configuration depicted in FIG.3B(1). This means that the contact elements of the third pair are different from the contact elements of the fourth pair, and at least one contact element of the third pair is different from the contact elements of the first pair.

The second four-point measurement is here performed 124 with the third pair of contact elements as current leads and the fourth pair of contact elements as voltage leads for determining a resistance value defining a sixth parameter value.

The model is modified 112 to describe a relation between the first and second quantities and the first, second, third, and sixth parameter values. The step of determining 114 the first and second quantities now comprises employing the first, second, third, and sixth parameter values in the model. The model is now based on two four-point measurements of different configurations performed at the same location instead of at two different locations. More precisely, A- and B-configurations shown in FIG.3 are used and the model is based on a combination of the above mentioned functions $R_A(y)$ and $R_B(y)$.

The pair of components of an anisotropic sheet conductance of a conductive sheet is understood to encompass a pair of spatial components representing the directional conductance of a conductive sheet having an anisotropic conductance. The axis of highest conductance and the axis of lowest conductance may represent a local anisotropic conductance for a portion of the conductive sheet. This is favourable if the orientation of the axes varies over the conductive sheet. The axis of highest conductance and the axis of lowest conductance may represent a global anisotropic conductance for the whole conductive sheet. This is favourable if the orientation of the axes varies little or nothing over the conductive sheet.

The first position may be represented by the position of a single contact point on said conductive surface, by the geometric centre of the contact points, or by the point in the centre between the contact points of the outermost contact elements. Similarly, the second position may be represented by the position of a single contact point on said conductive surface, by the geometric centre of the contact points, or by the point in the centre between the contact points of the outermost contact elements.

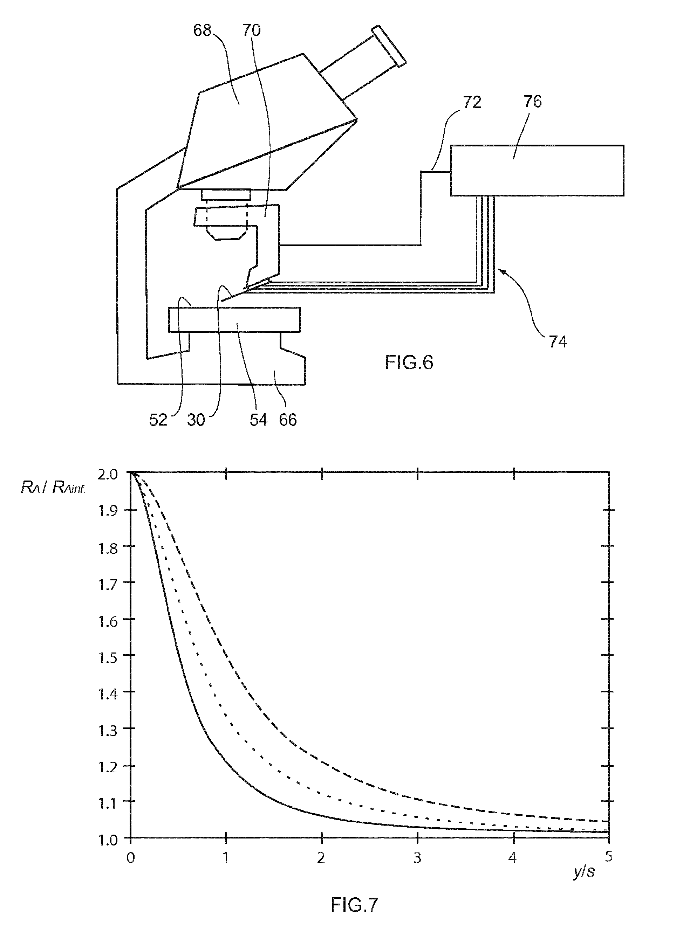

A system implementing a method of determining the anisotropic conductance of a conductive sheet is illustrated in FIG.6. The system has a four-point probe 30 with four contact elements, each defining a contact point for contacting and establishing an electrical connection to a conductive sheet 52 on a test sample or wafer 54. The contact points 42, 44, 46, and 48 are spatially separated from one another and positioned in a collinear relationship, as illustrated in FIG.1. The system further has a support 66 for supporting the test sample 54 and an actuator 70 for moving the contact elements relative to the conductive sheet 52 and for bringing the contact points of the four-point probe 30 in contact with the conductive sheet 52. The actuator 70 is mounted on a microscope 68, which is used for determining the distance between the contact points 42, 44, 46, and 48 and the edge of the conductive sheet 52. A control unit 76 is also part of the system and is connected to the actuator 70 by a control cable 72 for controlling the actuator and to the four-point probe 30 by signal cables 74 for implementing the method described above.

The general theoretical background for determining the components of an anisotropic sheet conductance according the present invention is presented below. A quasi two-dimensional sheet where current is assumed to flow in an xy-plane is considered. As a result, the relevant transport properties of the sheet or film (in absence of a magnetic flux density) may be represented by the sheet conductance tensor

$$\mathbf{G} = \begin{pmatrix} G_{xx} & 0 \\ 0 & G_{yy} \end{pmatrix}, \tag{1}$$

where the coordinate system is assumed to be aligned with the sample such that the tensor becomes diagonal. This diagonalization is always possible. Current transport in the film is divergence free, and thus the sheet current density fulfils $\nabla \cdot \mathbf{J}_s = 0$, except at current injection points. If the current $I_0$ is injected into an infinite sheet at the position $\mathbf{r} = \mathbf{r}_0$, the sheet current density must fulfil

$$\nabla \cdot \mathbf{J}_s = I_0 \delta(\mathbf{r} - \mathbf{r}_0). \tag{2}$$

The sheet current density is related to the electric field $\mathbf{E} = -\nabla\Phi$ and the potential $\Phi$ as follows $\mathbf{J}_s = \mathbf{G}\mathbf{E} = -\mathbf{G}\nabla\Phi$ and thus

$$-\nabla \cdot \mathbf{J}_s = \nabla \cdot \left( \mathbf{e}_x G_{xx} \frac{\partial \Phi}{\partial x} + \mathbf{e}_y G_{yy} \frac{\partial \Phi}{\partial y} \right) = G_{xx} \frac{\partial^2 \Phi}{\partial x^2} + G_{yy} \frac{\partial^2 \Phi}{\partial y^2} \tag{3}$$

$$= \sqrt{G_{xx}G_{yy}} \left( \sqrt{\frac{G_{xx}}{G_{yy}}} \frac{\partial^2 \Phi}{\partial x^2} + \sqrt{\frac{G_{yy}}{G_{xx}}} \frac{\partial^2 \Phi}{\partial y^2} \right) \tag{4}$$

$$= \sqrt{G_{xx}G_{yy}} \left( \frac{\partial^2 \Phi}{\partial X^2} + \frac{\partial^2 \Phi}{\partial Y^2} \right) = \sqrt{G_{xx}G_{yy}} \nabla_{\mathbf{R}}^2 \Phi \tag{5}$$

where scaled coordinates $\mathbf{R} = (X, Y)$ are used in the last expression. The scaled coordinates are related to the physical coordinates by

$$X = \sqrt[4]{\frac{G_{yy}}{G_{xx}}}\, x \text{, and } Y = \sqrt[4]{\frac{G_{xx}}{G_{yy}}}\, y \; . \tag{6}$$

Note, $\delta(\mathbf{r} - \mathbf{r}_0) = \delta(x - x_0)\delta(y - y_0) = \delta(X - X_0)\delta(Y - Y_0) = \delta(\mathbf{R} - \mathbf{R}_0)$ due to the properties of the delta function. It follows that expressed in scaled coordinates Eq. 2 becomes

$$-\sqrt{G_{xx}G_{yy}}\,\nabla^2_{\mathbf{R}}\Phi = I_0\,\delta(\mathbf{R} - \mathbf{R}_0) \tag{7}$$

with the solution

$$\Phi = \frac{I_0}{2\pi\sqrt{G_{xx}G_{yy}}}\ln\frac{1}{|\mathbf{R} - \mathbf{R}_0|} = \frac{I_0}{2\pi\sqrt{G_{xx}G_{yy}}}\ln\frac{1}{\sqrt{\sqrt{\frac{G_{yy}}{G_{xx}}}(x - x_{01})^2 + \sqrt{\frac{G_{xx}}{G_{yy}}}(y - y_0)^2}} \; . \tag{8}$$

From this solution (Greens function) more complicated problems may be constructed and solved using superposition.

An application of the general theory to a specific example with an infinite sheet and inline probes follows. With current injection ($+I_0$) and extraction ($-I_0$) points at r+ and $\mathbf{r}_-$, or in scaled coordinates at $\mathbf{R}_+$ and R-, the resulting potential becomes

$$\Phi_2 = \frac{I_0}{2\pi\sqrt{G_{xx}G_{yy}}}\ln\frac{|\mathbf{R} - \mathbf{R}_-|}{|\mathbf{R} - \mathbf{R}_+|} \tag{9}$$

$$= \frac{I_0}{2\pi\sqrt{G_{xx}G_{yy}}}\ln\frac{\sqrt{\sqrt{\frac{G_{yy}}{G_{xx}}}(x - x_-)^2 + \sqrt{\frac{G_{xx}}{G_{yy}}}(y - y_-)^2}}{\sqrt{\sqrt{\frac{G_{yy}}{G_{xx}}}(x - x_+)^2 + \sqrt{\frac{G_{xx}}{G_{yy}}}(y - y_+)^2}} \tag{10}$$

$$= \frac{I_0}{2\pi\sqrt{G_{xx}G_{yy}}}\ln\frac{\sqrt{(x - x_-)^2 + \frac{G_{xx}}{G_{yy}}(y - y_-)^2}}{\sqrt{(x - x_+)^2 + \frac{G_{xx}}{G_{yy}}(y - y_+)^2}} \; . \tag{11}$$

If we, without loss of generality, take $y_i = y_+ = y_-$ where $y_i$ is the position of probe pin $i \in [1, 2, 3, 4]$, the potential on the probe line $y = y_i$ becomes

$$\Phi_2(x) = \frac{I_0}{2\pi\sqrt{G_{xx}G_{yy}}} \ln \frac{\sqrt{(x-x_-)^2}}{\sqrt{(x-x_+)^2}} \qquad (12)$$

It follows that the anisotropy cannot be detected in such a measurement, and the outcome of a sheet resistance measurement would be $R_{sh} = (G_{xx}G_{yy})^{-1/2}$ independent of the orientation of the probe line.

An application of the general theory to a specific example with a single boundary and a semi-infinite sheet for in-line probes follows. The potential due to the two current probes can in this case be solved using the method of images. The result is then

$$\Phi_{22} = \frac{I_0}{2\pi\sqrt{G_{xx}G_{yy}}} \ln \frac{|\mathbf{R} - \mathbf{R}_-||\mathbf{R} - \mathbf{R}_-^*|}{|\mathbf{R} - \mathbf{R}_+||\mathbf{R} - \mathbf{R}_+^*|}, \qquad (13)$$

where $\mathbf{R}_i^*$ is the mirror image of $\mathbf{R}_i$ in the boundary. Without loss of generality, we may take the x-axis as the boundary and assume $\mathbf{r}_\pm = y e y \pm 3/2\, s e_x \Rightarrow \mathbf{R}_\pm = Y e_Y \pm 3/2\, s(G_{yy}/G_{xx})^{1/4}\, e_X = Y e_Y \pm 3/2\, S e_X$ and $\mathbf{r}_{\pm\varphi} = y e y \pm 1/2\, s e_x \Rightarrow \mathbf{R}_{\pm\varphi} = Y e_Y \pm 1/2\, s(G_{yy}/G_{xx})^{1/4}\, e_X = Y e_Y \pm 1/2\, S e_X$, where s is the probe pitch, while S is the scaled probe pitch, $\mathbf{r}_\pm$ are the current probe positions, while $\mathbf{r}_{\pm\varphi}$ are the potential probe positions, which here correspond to an A-configuration. The measured voltage in the A-configuration is then $V_A = \Phi_{22}(\mathbf{R}_{+\varphi}) - \Phi_{22}(\mathbf{R}_{-\varphi}) = 2\Phi_{22}(\mathbf{R}_{+\varphi})$, and therefore the measured transfer resistance is $R_A = 2\Phi_{22}(\mathbf{R}_{+\varphi})/I_0$ or

$$R_A(Y) = 2\frac{I_0}{2\pi\sqrt{G_{xx}G_{yy}}} \ln \sqrt{\frac{4S^2}{S^2}\frac{4(Y)^2 + 4S^2}{4(Y)^2 + S^2}} \qquad (14)$$

$$= 2\frac{I_0}{2\pi\sqrt{G_{xx}G_{yy}}} \ln \sqrt{4\frac{4\left(\frac{Y}{S}\right)^2 + 4}{4\left(\frac{Y}{S}\right)^2 + 1}} \qquad (15)$$

or

$$R_A(y) = \frac{I_0}{2\pi\sqrt{G_{xx}G_{yy}}} \ln \left( 4\frac{4\frac{G_{xx}}{G_{yy}}\left(\frac{y}{s}\right)^2 + 4}{4\frac{G_{xx}}{G_{yy}}\left(\frac{y}{s}\right)^2 + 1} \right) \qquad (16)$$

where $y$ is the distance from the boundary. It follows that measurements with varying probe pitch at constant distance from the boundary or with fixed probe pitch at varying distance from the boundary will reveal the anisotropy.

In a practical application it is useful to measure both $R_A$ and $R_B$ in order to perform position correction with the van der Pauw equation. In $R_B$ the pins can be placed with $\mathbf{R_+} = Y\mathbf{e}_Y + 1/2S\mathbf{e}_X$, R- = $Y\mathbf{e}_Y$ - 3/2$S\mathbf{e}_X$, $\mathbf{R_{+\varphi}} = Y\mathbf{e}_Y + 3/2S\mathbf{e}_X$, and $\mathbf{R_{-\varphi}} = Y\mathbf{e}_Y$ - 1/2$S\mathbf{e}_X$. Following $R_B$ is derived from Eq. 13

$$R_B(Y) = \frac{1}{2\pi\sqrt{G_{xx}G_{yy}}}\left(\ln\frac{\left|\mathbf{R_{+\varphi}} - \mathbf{R_-}\right|\left|\mathbf{R_{+\varphi}} - \mathbf{R_-^*}\right|}{\left|\mathbf{R_{+\varphi}} - \mathbf{R_+}\right|\left|\mathbf{R_{+\varphi}} - \mathbf{R_+^*}\right|} - \ln\frac{\left|\mathbf{R_{-\varphi}} - \mathbf{R_-}\right|\left|\mathbf{R_{-\varphi}} - \mathbf{R_-^*}\right|}{\left|\mathbf{R_{-\varphi}} - \mathbf{R_+}\right|\left|\mathbf{R_{-\varphi}} - \mathbf{R_+^*}\right|}\right) \quad (17)$$

$$= \frac{1}{2\pi\sqrt{G_{xx}G_{yy}}}\left(\ln\frac{\sqrt{9S^2}}{\sqrt{S^2}}\frac{\sqrt{4Y^2 + 9S^2}}{\sqrt{4Y^2 + S^2}} - \ln\frac{\sqrt{S^2}}{\sqrt{S^2}}\frac{\sqrt{4Y^2 + S^2}}{\sqrt{4Y^2 + (-S)^2}}\right) \quad (18)$$

$$= \frac{1}{4\pi\sqrt{G_{xx}G_{yy}}}\ln\frac{9\left(4\left(\frac{Y}{S}\right)^2 + 9\right)}{4\left(\frac{Y}{S}\right)^2 + 1} \quad (19)$$

or

$$R_B(y) = \frac{1}{4\pi\sqrt{G_{xx}G_{yy}}}\ln\frac{9\left(4\frac{G_{xx}}{G_{yy}}\left(\frac{y}{s}\right)^2 + 9\right)}{4\frac{G_{xx}}{G_{yy}}\left(\frac{y}{s}\right)^2 + 1}. \quad (20)$$

The relative $R_A$ resistance as a function of normalized boundary distance y/s for $G_{xx}/G_{yy} \in [0.5, 1, 2]$ is shown in FIG.7, where the normalization is to y/s $\rightarrow$ infinity and $G_{xx}/G_{yy}$ = 2 is represented by a solid line, $G_{xx}/G_{yy}$ = 1 is represented by a dotted line, and $G_{xx}/G_{yy}$ = 0.5 is represented by a dashed line.

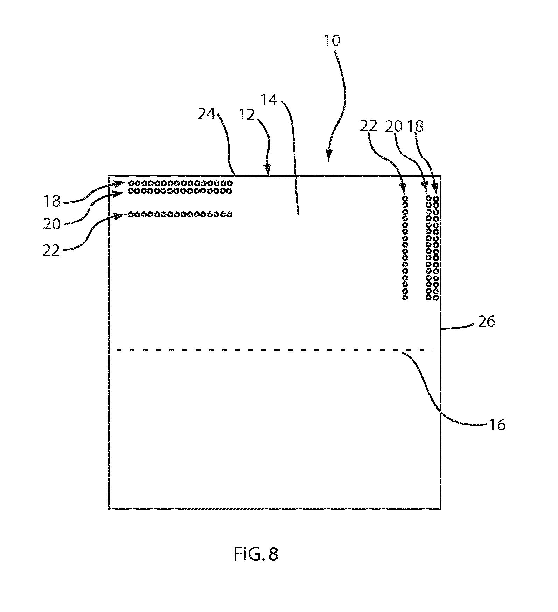

Measurements have been performed for verifying that the technique works. A Si carrier chip with 1 $\mu$m of grown $SiO_2$ was provided and 3 nm Ta, 30 nm of 80% Ni and 20% Fe alloy, 20 nm 80% Mn and 20% Ir alloy, and 3 nm Ta, which was sputtered on the stack for forming a conductive sheet. The stack was annealed in vacuum in a 20 mT field at 280°C after lithography. The measureable region or conductive sheet 14, which is illustrated in FIG.8, was 4 by 4 mm$^2$ square, which was defined lithographically. The sample has the axis of lowest conductivity 16 defined by the magnetic easy axis formed by the magnetic field during annealing. This resulted in an anisotropic conductance in the order of 2%, as measured on other samples produced by the same technique.

Measurements were conducted at the applicant's facilities on a CAPRES M150 tool in $\mu$RSP configuration. Micro four point probes ($\mu$4PP) with pitches 20 $\mu$m and 30 $\mu$m were used to conduct a series of measurements along two orthogonal edge portions, where one of the edge portions 24 is parallel to the axis of lowest conductivity 16 and the other 26 is at a right angle to this axis.

One anisotropy measurement consisted of three engagements or contacts; the first 18 a few $\mu$m from the edge 12, the second 20 approximately 2/3*$s$ from the edge 12, and the third 22 approximately 5*$s$ from the edge 12, where s is the probe pitch. To get significant statistics in the measurements, more than 300 anisotropy measurements were conducted along each of the edge portions. The probes were moved 7 $\mu$m (s = 20 $\mu$m) or 11 $\mu$m (s = 30 $\mu$m) parallel to the edge portions, in order to get many measurements without using the same contact points twice. Variations of four point probe resistance measurements $R_A$ and $R_B$ configurations (Eqs. 16 and 19) were used.

The acquired data was first phase filtered and configurations with large signal phase were rejected. Pseudo Rs values (i.e. where the edge influences the measurements) were calculated based on $R_A$ and $R_B$ pairs using the van der Pauw method. The pseudo Rs data were median filtered to reject outliers. The measurements at the three different engages of an anisotropy measurement were fitted to a curve describing the pseudo Rs as a function of distance to the edge by the least squares method. The behaviour of these functions is similar to the curves depicted in FIG.7.

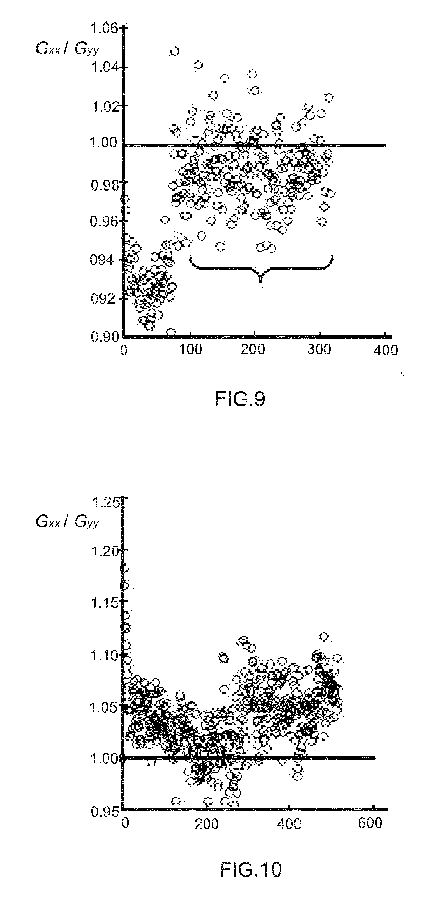

The measurements along the orthogonal edge portions 24 and 26 are illustrated in in FIGS. 9 and 10. The ratio $G_{xx}/G_{yy}$ is plotted along the y-axis, the order of the measurements is plotted along the x-axis, and the circles correspond to individual anisotropy measurements, each consisting of three engages at different offset to the edge. The solid line indicates unity, which is the expected value if no anisotropy is present. In FIG.9, the spatial separation of the contact points is s = 30 $\mu$m. The points of the x-axis are separated 11 $\mu$m along the edge 24 parallel to the axis of lowest conductivity 16. The first part of the measurement has a deviating sheet resistance and is therefore excluded from the analysis. In FIG.10, the spatial separation of the contact points is s = 20 $\mu$m. The points of the x-axis are separated 7 $\mu$m along an edge 26 orthogonal to the axis of lowest conductivity 16.

The $G_{xx}/Gyy$ average in FIG. 9 is 0.987$\pm$0.017 and in FIG.10 1.038$\pm$0.032. The $G_{xx}$ conductivity is parallel to the inline probe. In FIG.8 the $G_{xx}$ is thus parallel to the axis of lowest conductivity 16 when measuring along the edge 24; thus corresponding well with the measured $G_{xx}/G_{yy}$ ratio below unity in FIG.9. The same reasoning explains the measurement in FIG.10 being above unity.

ITEM LIST

10 sample
12 edge
14 conductive sheet
16 axis of lowest conductance
18 first engagements
20 second engagements
22 third engagements
24 edge portion parallel to magnetic easy axis
26 edge portion at right angle to magnetic easy axis
30 multi-point probe
32 contact element
34 contact element
36 contact element
38 contact element
40 tip of multi-point probe
42 contact point
44 contact point
46 contact point
48 contact point
50 test sample
52 conductive sheet
54 wafer
56 edge
58 planar surface
60 edge portion
62 line
64 surrounding area
66 support
68 microscope
70 actuator
72 control cable
74 signal cables
76 control unit

**Claims**

1. A method of determining a pair of components of an anisotropic sheet conductance of a conductive sheet with a multi-point probe, said conductive sheet having an edge and defining an axis of highest conductance and an axis of lowest conductance, and said multi-point probe comprising a plurality of contact elements, and each contact element defining a contact point for contacting and establishing an electrical connection to said conductive sheet, and said contact points of said plurality of contact elements being spatially separated from one another and positioned in a collinear relationship, said method comprising:

   - determining a first parameter value representing the spatial separation between said contact points,
   - contacting said conductive sheet with said contact points of said plurality of contact elements at a first position on said conductive sheet,
   - determining a second parameter value representing the distance between said first position and said edge of said conductive sheet,
   - selecting a first pair of contact elements and a second pair of contact elements from said plurality of contact elements, and the contact elements of said first pair being different from the contact elements of said second pair,
   - performing a first four-point measurement with said first pair of contact elements as current leads and said second pair of contact elements as voltage leads for determining a resistance value defining a third parameter value,
   - defining a first quantity representing the conductance of said conductive sheet along said axis of highest conductance and a second quantity representing the conductance of said conductive sheet along said axis of lowest conductance, said first and second quantities representing said pair of components,
   - defining a model describing a relation between said first and second quantities and said first, second, and third parameter values, and
   - determining said first and/or said second quantities by employing said first, second, and third parameter values in said model.

2. The method according to claim 1 **characterised by** further comprising:

   - contacting said conductive sheet with said contact points of said plurality of contact elements at a second position on said conductive sheet,
   - determining a fourth parameter value representing the distance between said second position and said edge of said conductive sheet,
   - performing a second four-point measurement with said first pair of contact elements as current leads and said second pair of contact elements as voltage leads for determining a resistance value defining a fifth parameter value: and
   said model comprising a function with an output representing a resistance value determined by a four-point measurement with said first pair of contact elements as current leads and said second pair of contact elements as voltage leads, a known constant representing said first parameter value, a first unknown constant representing said first quantity, a second unknown constant representing said second quantity, and a variable representing the distance from said first and second positions to said edge; and
   said step of determining said first and second quantities further comprising: adjusting said first unknown and said second unknown for fitting said function to said second parameter value paired with said third parameter value and said fourth parameter value paired with said fifth parameter value.

3. The method according to any of the claims 1-2 **characterised by** further comprising:

   - orienting said contact points in a parallel relationship with said axis of highest conductance or said axis of lowest conductance.

4. The method according to any of the claims 1-3 **characterised by** said edge comprising a straight edge portion, and said method further comprising:

   - orienting said contact points in a parallel relationship with said straight edge portion.

5. The method according to any of the claims 1-4 **characterised by** said edge comprising a straight edge portion being parallel to said axis of highest conductance or said axis of lowest conductance, and said method further comprising:

- orienting said contact points in a parallel relationship with said straight edge portion.

6.  The method according to any of the claims 1-5 **characterized by** said second parameter value representing the shortest distance between said first position and said edge of said conductive sheet.

7.  The method according to any of the claims 1-4 **characterized by** further comprising:

    - determining the orientation of said contact points relative to said axis of highest conductance; and
    said step of defining a model further comprising: said model being adjusted to reflect the determined orientation of said contact points relative to said axis of highest conductance.

8.  The method according to any of the claims 1-7 **characterized by** said contact points being evenly spaced apart.

9.  The method according to any of the claims 1-8 **characterized by** the model describing a relation between said first and second quantities and said first, second, and third (and optionally fourth and/or fifth) parameter values being based on a relation equivalent to:

$$\nabla \cdot \mathbf{J}_s = I_0\, \delta(\mathbf{r} - \mathbf{r}_0),$$

where $\mathbf{J}_s$ is a vector representing the sheet current density, $I_0$ is a number representing the current injected by the current leads at said first position represented by the vector $\mathbf{r}_0$, and on a relation equivalent to:

$$\mathbf{J}_s = \mathbf{G}\, \mathbf{E},$$

where $\mathbf{J}_s$ is the vector representing the sheet current density, $\mathbf{E}$ is a vector representing the electrical field generated by the current injected by the current leads, and $\mathbf{G}$ is a matrix representing a sheet conductance tensor based at least on the determined orientation of said contact points relative to said axis of highest conductance and on said first and second quantities.

10. The method according to any of the claims 1-9 **characterized by** said model being based on a relation equivalent to:

$$\Phi = \frac{I_0}{2\pi\sqrt{G_{xx}G_{yy}}} \ln \frac{1}{\sqrt{\sqrt{\frac{G_{yy}}{G_{xx}}}(x-x_0)^2 + \sqrt{\frac{G_{xx}}{G_{yy}}}(y-y_0)^2}},$$

where
$\Phi$ is the potential at a point on said conductive sheet represented by the coordinates x and $y$, $I_0$ is a number representing the current injected by the current leads at said first position represented by the coordinates $x_0$ and $y_0$, $G_{xx}$ is said first quantity, and $G_{yy}$ is said second quantity.

11. The method according to any of the claims 1-10 **characterized by** said plurality of contact elements being constituted by a first, a second, a third, and a fourth contact element, and the contact points of said first, a second, a third, and a fourth contact element being ordered sequentially in said collinear relationship; and said first pair of contact elements consisting of said first and fourth contact elements, and said second pair of contact elements consisting of said second and third contact elements, or said first pair of contact elements consisting of said second and third contact elements, and said second pair of contact elements consisting of said first and fourth elements.

12. The method according to claim 11 **characterized by** said model being based on a function equivalent to:

$$R_A(y) = \frac{1}{2\pi\sqrt{G_{xx}G_{yy}}} \ln\left(4\frac{4\frac{G_{xx}}{G_{yy}}\left(\frac{y}{s}\right)^2 + 4}{4\frac{G_{xx}}{G_{yy}}\left(\frac{y}{s}\right)^2 + 1}\right),$$

where s is said first parameter value, $y$ is said second parameter value, $R_A$ is said third parameter value, $G_{xx}$ is said first quantity, and $G_{yy}$ is said second quantity.

**13.** The method according to any of the claims 1-10 **characterized by** said plurality of contact elements being constituted by a first, a second, a third, and a fourth contact element, and the contact points of said first, a second, a third, and a fourth contact element being ordered sequentially in said collinear relationship; and said first pair of contact elements consisting of said second and fourth contact elements, and said second pair of contact elements consisting of said first and third contact elements, or said first pair of contact elements consisting of said first and third contact elements, and said second pair of contact elements consisting of said second and fourth contact elements.

**14.** The method according to claim 13 **characterized by** said model being based on a function equivalent to:

$$R_B(y) = \frac{1}{4\pi\sqrt{G_{xx}G_{yy}}} \ln\frac{9\cdot\left(4\frac{G_{xx}}{G_{yy}}\left(\frac{y}{s}\right)^2 + 9\right)}{4\frac{G_{xx}}{G_{yy}}\left(\frac{y}{s}\right)^2 + 1},$$

where
s is said first parameter value, $y$ is said second parameter value, $R_B$ is said third parameter value, $G_{xx}$ is said first quantity, and $G_{yy}$ is said second quantity.

**15.** A system for determining a pair of components of an anisotropic sheet conductance of a conductive sheet on a test sample, said conductive sheet having an edge and defining an axis of highest conductance and an axis of lowest conductance, said system comprising:

(a) a multi-point probe comprising a plurality of contact elements, and each contact element defining a contact point for contacting and establishing an electrical connection to said conductive sheet, and said contact points of said plurality of contact elements being spatially separated from one another and positioned in a collinear relationship,
(b) a support for supporting said test sample,
(c) an actuator for moving said contact elements relative to said conductive sheet and for bringing said contact points of said plurality of contact elements in contact with said conductive sheet, and
(d) a control unit for controlling said actuator and for implementing the method according to any of the claims 1-14.

FIG. 1

FIG. 2

FIG.3A(1)

FIG.3A(2)

FIG.3B(1)

FIG.3B(2)

FIG.4

FIG.5

FIG.6

FIG.7

FIG. 8

FIG.9

FIG.10

## EUROPEAN SEARCH REPORT

Application Number

EP 13 19 2357

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FILIPPOV V V ET AL: "Method of measurement of anisotropic electrical conductivity of semiconductor wafers and films", KONDENSIROVANNYE SREDY I MEZFAZNYE GRANICY = CONDENSED MATTER AND INTERPHASES, VORONEZSKIJ GOSUDARSTVENNYJ UNIVERSITET, VORONEZ, vol. 15, no. 3, 26 September 2013 (2013-09-26), pages 357-360, XP008170543, RU ISSN: 1606-867X * abstract; figure 1 * * Equations (8), (11), (15) to (17); page 357, left-hand column, last paragraph - page 358, left-hand column, paragraph 1; table * | 1-11,13, 14 | INV. G01R27/00 G01R31/26 |
| X,D | WO 2012/083955 A1 (CAPRES AS [DK]; WEI FEI [DK]; PETERSEN DIRCH HJORTH [DK]; HANSEN OLE []) 28 June 2012 (2012-06-28) * abstract; claim 45; figures 1-3C(2), 4B, 6-8B(4), 10 * * page 1, paragraph 1-3 * * page 25, last paragraph - page 26, paragraph 3 * * page 29, line 21 - page 30, line 16 * | 1-15 | TECHNICAL FIELDS SEARCHED (IPC) G01R H01L |

-----

-/--

The present search report has been drawn up for all claims

| Place of search | Date of completion of the search | Examiner |
|---|---|---|
| Berlin | 16 July 2014 | Fritz, Stephan C. |

EPO FORM 1503 03.82 (P04C01)

Europäisches
Patentamt

European
Patent Office

Office européen
des brevets

# EUROPEAN SEARCH REPORT

Application Number

EP 13 19 2357

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | V. V. FILIPPOV: "A procedure for determining components of the specific electrical conductivity tensor of anisotropic semiconductor films", INSTRUMENTS AND EXPERIMENTAL TECHNIQUES, vol. 51, no. 4, 2008, pages 630-633, XP55128291, ISSN: 0020-4412, DOI: 10.1134/S0020441208040222 * the whole document * | 1-15 | |
| A | WO 2005/124371 A1 (CAPRES AS [DK]; NIELSEN PETER FOLMER [DK]; PETERSEN PETER R E [DK]; HA) 29 December 2005 (2005-12-29) * claims 21-28; figures 14a-16 * * page 47, line 4 - line 10 * | 1-15 | |

TECHNICAL FIELDS
SEARCHED      (IPC)

The present search report has been drawn up for all claims

| Place of search | Date of completion of the search | Examiner |
|---|---|---|
| Berlin | 16 July 2014 | Fritz, Stephan C. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................................................

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                     EP 13 19 2357

This annex lists the patent family members relating to the patent documents cited in  the above-mentioned European search report.
The members are as contained in the European Patent Office EDP file on
The European Patent Office is in no way liable for these particulars which are merely given for the purpose of information.

16-07-2014

| Patent document cited in search report | | Publication date | Patent family member(s) | | Publication date |
|---|---|---|---|---|---|
| WO 2012083955 | A1 | 28-06-2012 | CN | 103380368 A | 30-10-2013 |
| | | | EP | 2656056 A1 | 30-10-2013 |
| | | | JP | 2014503114 A | 06-02-2014 |
| | | | KR | 20130132558 A | 04-12-2013 |
| | | | SG | 191251 A1 | 31-07-2013 |
| | | | US | 2014015552 A1 | 16-01-2014 |
| | | | WO | 2012083955 A1 | 28-06-2012 |
| WO 2005124371 | A1 | 29-12-2005 | CN | 102305896 A | 04-01-2012 |
| | | | EP | 1782078 A1 | 09-05-2007 |
| | | | EP | 2463667 A2 | 13-06-2012 |
| | | | JP | 5192232 B2 | 08-05-2013 |
| | | | JP | 2008503734 A | 07-02-2008 |
| | | | JP | 2012211911 A | 01-11-2012 |
| | | | KR | 20070045196 A | 02-05-2007 |
| | | | US | 2009009200 A1 | 08-01-2009 |
| | | | US | 2011169515 A1 | 14-07-2011 |
| | | | WO | 2005124371 A1 | 29-12-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040056674 A1

- WO 2012083955 A

**Non-patent literature cited in the description**

- *Phys. Rev. Lett.,* 2003, vol. 91 (3), 036805